(19) Europäisches Patentamt
European Patent Office
Office européen des brevets

(11) Publication number : **0 109 617 B2**

(12) **NEW EUROPEAN PATENT SPECIFICATION**

(45) Date of publication of the new patent specification : **25.09.91 Bulletin 91/39**

(51) Int. Cl.$^5$ : **G03F 7/004,** C08G 2/14, C08G 2/20

(21) Application number : **83111232.1**

(22) Date of filing : **10.11.83**

# (54) Positive type, radiation-sensitive organic polymer materials.

(30) Priority : **15.11.82 JP 198958/82**

(43) Date of publication of application : **30.05.84 Bulletin 84/22**

(45) Publication of the grant of the patent : **02.04.86 Bulletin 86/14**

(45) Mention of the opposition decision : **25.09.91 Bulletin 91/39**

(84) Designated Contracting States : **DE GB**

(56) References cited :
**DE-A- 2 217 744**
**US-A- 2 588 083**
**US-A- 3 915 706**
**US-A- 3 923 514**
**US-A- 4 086 092**
**US-A- 4 357 369**

(56) References cited :
**XEROX DISCLOSURE JOURNAL, volume 1, no. 2, February 1976, Stamford Connecticut (USA) W.W. LIMBURG et al. "Imaging method based on photoinduced depolymerization of poly(acetaldehyde)", page 17**
**Polymer Bulletin 8 (1982), pp. 469-472**

(73) Proprietor : **HITACHI, LTD.**
**6, Kanda Surugadai 4-chome**
**Chiyoda-ku, Tokyo 100 (JP)**

(72) Inventor : **Nate, Kazuo**
**1670-115, Naruse**
**Machida-shi (JP)**
Inventor : **Inoue, Takashi**
**Hitachifujimiryo 1545, Yoshidacho**
**Totsuka-ku Yokohama (JP)**
Inventor : **Yokono, Hitoshi**
**Tsurumaki-Haitsu A102 3-21-6, Mirokuji**
**Fujisawa-shi (JP)**

(74) Representative : **Patentanwälte Beetz sen. - Beetz jun. Timpe - Siegfried - Schmitt-Fumian**
**Steinsdorfstrasse 10**
**W-8000 München 22 (DE)**

EP 0 109 617 B2

## Description

This invention relates to positive type radiation-sensitive organic polymer materials suitable for forming a fine pattern, and particularly for producing semiconductor devices, magnetic bubble memories, integrated circuits, etc.

Recently, there is a demand for forming patterns having a width of less than 1 μm for semiconductor devices, magnetic bubble memories; integrated circuits, etc. with a higher load density and a higher integration.

To meet such requirements, a lithographic technology using a high energy radiation such as electron beams, X-rays, ion beams, etc. has been studied.

Radiation-sensitive organic polymer materials for such applications can be classified into positive type and negative type materials:

(a) Positive type materials undergo scission reactions in the irradiated areas which turn soluble in a developing solution. Typical examples therefor are poly(methyl methacrylate) and poly(1-butenesulfone).

(b) Negative type materials undergo cross-linking in the irradiated areas and turn insoluble in a developing solution.

Positive type, radiation-sensitive organic polymer materials have a higher resolving power than the negative type materials and thus are suitable for forming finer patterns. However, their sensitivity is only 1/10 to 1/100 of that negative type materials, which necessitates longer exposure times (M. J. Bowden et al., Solid State Technology, Vol. 22, No. 5 (1979) pages 72—82).

Furthermore, the conventional positive type and negative type radiation-sensitive organic polymer materials must be developed in a wet process.

DE-A1 22 17 744 discloses radiation sensitive polymers having silane groups in their side chains, whereby the chemical structure of the main chain base polymer is discussed as being not critical, and accordingly, e.g. usual positive and negative type resist materials can be used, such as polymers having dimerizable side chains, polymers crosslinkable via sulfazido groups, polymers having chalcone side chains, ethylenically unsaturated compounds, polymers having diazoquinone groups, etc.

US-A 4 357 369 discloses positive resist materials comprising a poly(silane sulfone) copolymer which has silane groups in the side chains and vinylsulfone groups in the macromolecular main chain. These materials are designed to withstand plasma etching without significant loss of resolution. Corresponding resist films are developed after radiation exposure with a suitable development solvent to remove the solubilized irradiated portions thereof.

Positive type imaging systems on the basis of polyaldehydes are known from US-A 3 915 706 and 3 923 514, wherein the side chains of the polyaldehyde main chain are hydrogen or eventually halogenated alkyl radicals or cyano substituted hydrocarbon groups.

These polyaldehyde based resists are decomposed by radiation in the irradiated areas and are indicated to be useful for relief printing masters (US-A 3 923 514).

The object on the present invention is to provide positive type radiation-sensitive organic polymer materials having a high sensitivity to high energy level radiation such as electron beams, X-rays, ion beams, etc. and a high resolving power and being capable of forming a finer pattern and requiring no special development which can be used as such and in corresponding resists.

This object is achieved according to the claims 1 and 4. The dependent claims refer to preferred embodiments.

Homopolymers of aliphatic aldehyde have a high crystallinity and are sparingly soluble in organic solvents. Thus, homopolymers of aliphatic aldehyds are not suited as resist materials. Therefore, it has been tried to improve the solubility of aldehyde polymers in organic solvents to obtain polymers applicable as resist materials.

Aldehyde copolymers obtained by anionic polymerization of a mixture containing at least two kinds of aliphatic aldehydes have an improved solubility, as compared with the corresponding homopolymers, but the solubility is not always satisfactory for the application as a resist material.

In this connection, aliphatic aldehydes having Si in their molecular chains have been studied. As a result, it has been found that polymers obtained by homopolymerization of aliphatic aldehydes containing Si in their molecular chain or by copolymerization thereof with an aliphatic aldehyde have a distinguished solubility in organic solvents and a high sensitivity to radiation and can be used as resist materials.

The positive type radiation-sensitive organic polymers according to the invention are characterized by a homopolymer of an aliphatic aldehyde represented by the general formula I

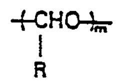

(I)

or

a copolymer of two aliphatic aldehydes represented by the general formula II

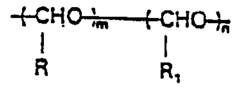

(II).

wherein are:

R $C_{1-8}$-alkyl, halogenated $C_{1-8}$-alkyl, aralkyl or halogenated aralkyl, each substituent R containing at least one Si atom in its molecular chain, and

$R_1$ $C_{1-8}$-alkyl, halogenated $C_{1-8}$-alkyl, aralkyl or halogenated aralkyl.

Aliphatic aldehydes represented by the unit

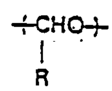

in the general formulae I and II include, for example, β-trimethylsilylpropanal, β-triethylsilylpropanal, β-trimethylsilylbutanal, and β-triethylsilylbutanal, among which β-trimethylsilylpropanal is most preferable.

Aliphatic aldehydes represented by the unit

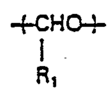

in the general formula II include, for example, ethanal, propanal, n-butanal, n-pentanal, n-hexanal, and β-phenylpropanal.

The synthesis of some monomeric organosilicon aldehydes has been known from US-A 2 588 083, e.g. of isomeric trimethylsilylpropionaldehydes and trimethylsilylbutyraldehydes. This synthesis is based on the so-called oxo synthesis. Furthermore, example 3 of this reference relates to the generation of aldehyde groups in an alkenyl-polysiloxane by means of oxo synthesis, wherein the aldehyde groups are present in side chains. It is indicated that these organosilicon aldehydes may be used for making various resins with different types of phenols, ureas, melamines, etc, and as perfumes and flavours because of their pleasant odor.

The polymers represented by the general formulae I and II can be obtained by anionic polymerization. For the polymerization, a catalyst can be used.

Such catalysts are, for example, dimethylaluminum diphenyl amide, diethylaluminum diphenyl amide, ethylaluminum-bis (diphenyl amide), ethylzinc diphenyl amide and ethylmagnesium diphenyl amide. The catalyst is used in an amount of 0,1 to 5 mole-%, based on the monomers, and in a solution in a hydrocarbon solvent such as toluene, etc. or in an ether such as diethylether, etc.

The polymerization is carried out at 0 to 100°C, preferably at 50 to 80°C, in an inert gas atmosphere such as nitrogen gas.

The present positive type radiation-sensitive organic polymer materials are dissolved in an organic solvent such as toluene, xylene, chloroform, etc. to make a resist. The resist can be applied by spin coating or dipping. The resulting coating film is then heated to an appropriate temperature to remove the solvent by evaporation. Then, the coating film is irradiated in a desired pattern. The irradiated areas are disintegrated in a chain reaction manner and scattered off, whereby a pattern can be obtained without any special developing step.

The present polymer materials have increased absorptivity to radiation such as electron beams. X-rays, ion beams, etc. and increased solubility in organic solvents and can also be developed with a toluene-isopropanol solvent mixture according to the wet process.

The present polymer materials can also be used as photosensitive materials.

In the following, the present invention is described in more detail, referring to Preparatory Examples and

Examples.

Preparatory Example 1

Synthesis of diethylaluminum diphenylamide.

$(C_2H_5)_2AlN(C_6H_5)_2$ was prepared in the following manner:

A four-necked flask having a net capacity of 200 ml and equipped with a stirrer, a dropping funnel, a three-way cock and a thermometer was thoroughly flushed with nitrogen. Subsequently, 33 ml of toluene and 14,5 g (0,127 moles) of $(CH_3CH_2)_3Al$ were introduced into the flask in a nitrogen gas stream through the three-way cock by a syringe.

After the mixture was stirred for a while to obtain a uniform solution a solution of 21,4 g (0,127 moles) of diphenylamine in 40 ml of toluene was dropwise added with ice cooling. After the dropwise addition, the reaction mixture was heated to 60°C, and gently stirred at that temperature for 2 hours to complete the reaction.

The thus formed $(C_2H_5)_2AlN(C_6H_5)_2$ was preserved as such in the toluene solution in a container with a three-way cock under nitrogen gas.

Preparatory Example 2

Synthesis of β-trimethylsilylpropanal

β-Trimethylsilylpropanal, an aldehyde monomer containing a silicon atom, was prepared in the following manner:

At first, 300 ml of tetrahydrofuran, 3,04 g (0,44 moles) of finely milled lithium, and 54,25 g (0,5 moles) of trimethylsilyl chloride were placed in a 4-necked flask having a net capacity of 500 ml and equipped with a stirrer, a dropping funnel, a thermometer and a cooling pipe. subsequently, 11,2 g (0,2 moles) of acrolein were added thereto with stirring over about one hour, while keeping the temperature of the reaction system at 0°C. The mixture was then continuously stirred at room temperature for 15 hours.

After the end of reaction, lithium and lithium chloride were removed therefrom by filtration, and tetrahydrofuran and excess trimethylsilyl chloride were distilled off. By distillation under reduced pressure, $(CH_3)_3SiCH_2—CH=CH—O—Si(CH_3)_3$ was obtained (boiling point: 100°C/4 kPa). This compound was then left standing in HCl-acetone for one hour to effect hydrolysis, and distilled under reduced pressure, whereby β-trimethylsilylpropanal was obtained (boiling point: 60°C/4 kPa).

Preparatory Examples 3—5

Preparation of aldehyde homo- and copolymers.

The polymerizations were conducted in a polymerization tube with a three-way cock. Predetermined amounts of aldehyde monomers and a solvent (toluene) were introduced into a cylindrical polymerization vessel having a net capacity of about 100 ml in a nitrogen gas stream through the three-way cock by a syringe.

The reaction vessel containing the monomer solution was cooled to 0°C in an ice-water bath, and a predetermined amount of the catalyst solution prepared in Preparatory Example 1 was slowly added while vigorously shaking the vessel.

After the addition of the catalyst, the reaction vessel was cooled to —78°C in a dry ice-acetone bath and left standing for a predetermined time to effect polymerization. After the end of polymerization, the polymerization mixture was treated with ammoniacal methanol to decompose the catalyst, poured into methanol and left standing for one day, then separated by filtration, washed several times with methanol, and dried in vacuum.

In some cases, the monomer solution was added to the catalyst solution to effect polymerization.

Polymers of various compositions thus prepared are shown in Table 1.

The composition of the copolymers was determined by elemental analysis or by analysis of the composition of a gas generated by thermal analysis.

TABLE 1

| Preparatory Example No. | Composition of charged monomer (mole-%) | Degree of polymerization (%) | Polymer composition (mole-% of TMS-PA) | General formula of the polymer |
|---|---|---|---|---|
| 3 | TMS-PA(100) | 45 | 100 | 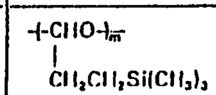 |
| 4 | TMS-PA(50)-BA(50) | 48 | 45 | 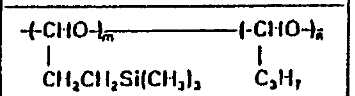 |
| 5 | TMS-PA(50)-PA(50) | 48 | 45 | 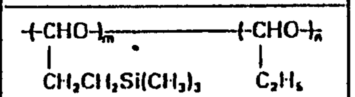 |

| | |
|---|---|
| Polymerization time: | 24 hours; |
| Total amount of monomers: | 100 mmoles; |
| Solvent: | toluene; |
| Total amount of reaction mixture: | 27 ml: |
| Initiator: | $(C_2H_5)_2AlN(C_6H_5)_2$ 0,18 mmoles; |
| Abbreviations for the monomers: | |
| TMS-PA: | β-trimethylsilylpropanal |
| BA: | butyl aldehyde |
| PA: | propanal. |

Example 1

The polymer of β-trimethylsilylpropanal obtained in Preparatory Example 3 was dissolved in chloroform to prepare a 0,2 wt.-% resist solution. The resist solution was then applied onto a silicon wafer and prebaked at 80°C for 20 minutes to form a polymer film having a thickness of 0,3 μm. Then, the silicon wafer was placed in an electron beam irradiator and subjected to irradiation with locally different irradiation dosages by electron beams of an acceleration voltage of 20 kV in vacuum. As a result, the irradiated areas were thinned without applying any developing treatment. The tickness of the residual polymer film was measured at irradiated areas with different irradiation dosages by means of a Taly step film thickness gauge. The residual film thickness (normalized) was plotted versus the irradiation dosage (coulomb/cm²) to obtain an irradiation characteristic curve showing an electron beam-sensitive characteristic.

The minimum irradiation dosage at which the residual film ratio is zero was obtained from the curve. It was found to be $8 \cdot 10^{-7}$ coulomb/cm². The present resist was a positive type resist having a very high sensitivity. As compared with the electron beam sensitivity of polymethyl methacrylate as a typical positive type resist which is $1 \cdot 10^{-4}$ coulomb/cm², the present positive type resist had a higher sensitivity by at least two decades.

Example 2

The copolymer of β-trimethylsilylpropanal with butylaldehyde prepared in Preparatory Example 4 was dissolved in toluene to prepare a 1 wt.-% resist solution. The resist solution was then applied onto a silicon wafer and prebaked at 80°C for 20 minutes to obtain a polymer film having a thickness of 2 μm. Then, the silicon wafer was placed in a soft X-rays generator and irradiated with soft X-rays having a wavelength of 0,42 nm (4,2 Å) generated by a rotating, water-cooled silver target at 10 kW in vacuum. The relationship between the residual film thickness (normalized) and the irradiation dosage (mJ/cm²) was determined. The minimum irradiation dosage at which the film thickness was zero was found to be 10 mJ/cm². The present resist was a positive type resist having a very high sensitivity.

Examples 3—7

Aldehyde copolymers prepared in a manner similar to that of Preparatory Examples 4 and 5 were each dissolved separately in xylene to prepare approximately 1 wt.-% resist solutions. The resist solutions were each applied to silicon wafers and prebaked at 80°C for 20 minutes to obtain polymer films having a thickness of about 2 μm. The silicon wafers were then irradiated with an electron beam of an acceleration voltage of 20 kV or soft X-rays (AlKα. MoLα or AgLα) of 10 kW to determine the electron beam or soft X-rays sensitivity. The results are summarized in Table 2. It was found that all of the present resists had a high radiation sensitivity and were positive type resists.

TABLE 2

| Example No. | Radiation-sensitive polymer material (mole-%) | Electron beam sensitivity ($C/cm^2$) or soft X-rays sensitivity ($mJ/cm^2$) |
|---|---|---|
| 3 | TMS-PA(45)-BA(55) | 10 $mJ/cm^2$ (MoLα) |
| 4 | " | 20 $mJ/cm^2$ (AlKα) |
| 5 | TMS-PA(45)-PA(55) | $9 \cdot 10^{-7}$ $C/cm^2$ |
| 6 | " | 18 $mJ/cm^2$ (MoLα) |
| 7 | " | 10 $mJ/cm^2$ (AgLα) |

TMS-PA: β-trimethylsilylpropanal BA: butylaldehyde PA: propanal

Comparative Example

A homopolymer of acetaldehyde and a homopolymer of butylaldehyde were tested in the same manner as in Example 1 to evaluate their applicability as resist materials. It was found that these resist materials are not soluble in the ordinary organic solvents. Accordingly, these materials are not practically applicable.

**Claims**

1. Positive type radiation-sensitive organic polymer materials, characterized by a homopolymer of an aliphatic aldehyde represented by the general formula I

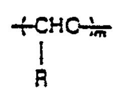

(I)

or

a copolymer of two aliphatic aldehydes represented by the general formula II

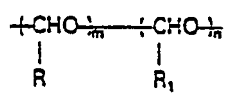

(II),

wherein are:

R $C_{1-8}$-alkyl, halogenated $C_{1-8}$-alkyl, aralkyl or halogenated aralkyl, each substituent R containing at least one Si atom in its molecular chain, and

$R_1$ $C_{1-8}$ alkyl, halogenated $C_{1-8}$-alkyl, aralkyl or halogenated aralkyl.

2. Polymer materials according to claim 1, characterized in that the units

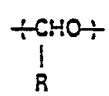

in the homopolymer of the formula I or the copolymer of the formula II are of β-trimethylsilylpropanal, β-triethylsilylpropanal, β-trimethylsilylbutanal or β-triethylsilylbutanal, and the units

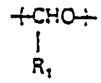

in the copolymer of the formula II are of ethanal, propanal, n-butanal, n-pentanal, n-hexanal or β-phenylpropanal.

3. Polymer materials according to claims 1 or 2, characterized in that the copolymer consists of either 45 mole-% of β-trimethylsilylpropanal and 55 mole-% of butylaldehyde, or
45 mole-% of β-trimethylsilylpropanal and 55 mole-% of propanal.

4. Use of the organic polymer materials according to one of claims 1 to 3 as or in positive type resists.

## Patentansprüche

1. Strahlungsempfindliches organisches Polymermaterial vom Positivtyp, gekennzeichnet durch ein aliphatisches Aldehyd-Homopolymer der allgemeinen Formel I

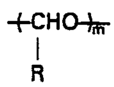 (I)

oder
ein Copolymer von zwei aliphatischen Aldehyden der allmeinen Formel II

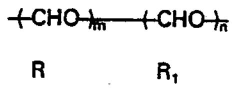 (II),

wobei bedeuten:
R $C_{1-8}$-Alkyl, halogeniertes $C_{1-8}$-Alkyl, Arylalkyl oder halogeniertes Arylalkyl, wobei jeder Substituent R mindestens ein Si-Atom in seiner Molekülkette enthält, und
$R_1$ $C_{1-8}$-Alkyl, halogeniertes $C_{1-8}$-Alkyl, Arylalkyl oder halogeniertes Arylalkyl.

2. Polymermaterial nach Anspruch 1, dadurch gekennzeichnet, daß die

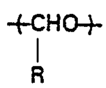

Einheiten im Homopolymer der Formel I oder im Copolymer der Formel II β-Trimethylsilylpropanal, β-Triethylsilylpropanal, β-Trimethylsilylbutanal oder β-Triethylsilylbutanal und die

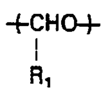

Einheiten des Copolymers der Formel II Ethanal, Propanal, n-Butanal, n-Pentanal, n-Hexanal oder β-Phenylpropanal sind.

3. Polymermaterial nach Anspruch 1 oder 2, dadurch gekennzeichnet, daß das Copolymer entweder aus 45 Molprozent β-Trimethylsilylpropanal und 55 Molprozent Butylaldehyd oder aus
45 Molprozent β-Trimethylsilylpropanal und 55 Molprozent Propanal besteht.

4. Verwendung des organischen Polymermaterials gemäß einem der Ansprüche 1 bis 3 als oder in Photoresists.

## Revendications

1. Matériau polymère organique sensible aux radiations de type positif, caractérisé par un homopolymère

d'un aldéhyde aliphatique représenté par la formule générale I

$$\left(\underset{\displaystyle R}{\underset{|}{CHO}}\right)_m \qquad (I)$$

ou

un copolymère de deux aldéhydes aliphatiques représenté par la formule générale II

$$\left(\underset{\displaystyle R}{\underset{|}{CHO}}\right)_m\!-\!\left(\underset{\displaystyle R_1}{\underset{|}{CHO}}\right)_n \qquad (II),$$

dans lesquelles

R est un alkyle en $C_{1-8}$, un alkyle en $C_{1-8}$ halogéné, un aralkyle ou un aralkyle halogéné, chaque radical R contenant au moins un atome Si dans sa chaîne moléculaire, et

$R_1$ est un alkyle en $C_{1-8}$, un alkyle en $C_{1-8}$ halogéné, un aralkyle ou un aralkyle halogéné.

2. Matériau polymère selon la revendication 1 caractérisé en ce que les unités

$$\left(\underset{\displaystyle R}{\underset{|}{CHO}}\right)$$

de l'homopolymère de la formule I ou du copolymère de la formule II sont le β-triméthylsilylpropanal, le β-triéthylsilylpropanal, le β-triméthylsilylbutanal ou le β-triéthylsilylbutanal et les unités

$$\left(\underset{\displaystyle R_1}{\underset{|}{CHO}}\right)$$

du copolymère de la formule II sont l'éthanal, le propanal, le n-butanal, le n-pentanal, le n-hexanal ou le β-phénylpropanal.

3. Matériau polymère selon la revendication 1 ou 2, caractérisé en ce que le copolymère consiste soit en 45 % en mole de β-triméthylsilylpropanal et en 55 % en mole de butylaldéhyde, soit en 45 % en mole de β-triméthylsilylpropanal et en 55 % en mole de propanal.

4. Utilisation d'un matériau polymère organique selon l'une des revendications 1 à 3 comme revêtement de type positif ou dans des revêtements de type positif.